(19) Europäisches Patentamt
European Patent Office
Office européen des brevets

(11) Veröffentlichungsnummer : **0 157 931**
**B1**

(12) # EUROPÄISCHE PATENTSCHRIFT

(45) Veröffentlichungstag der Patentschrift : **04.03.87**

(21) Anmeldenummer : **84115194.7**

(22) Anmeldetag : **12.12.84**

(51) Int. Cl.⁴ : **C 08 G 73/18**, C 08 G 73/20, G 03 C 1/70, G 03 F 7/26, H 01 L 21/47

(54) **Verfahren zur Herstellung von Polyimidazol- und Polyimidazopyrrolon-Vorstufen.**

(30) Priorität : **29.03.84 DE 3411706**

(43) Veröffentlichungstag der Anmeldung : **16.10.85 Patentblatt 85/42**

(45) Bekanntmachung des Hinweises auf die Patenterteilung : **04.03.87 Patentblatt 87/10**

(84) Benannte Vertragsstaaten : **AT BE CH DE FR GB IT LI NL SE**

(56) Entgegenhaltungen :
**DE-A- 2 933 819**
**US-A- 3 574 170**
**L. UND M. FIESER "Organische Chemie", 1965 VERLAG CHEMIE Weinheim/Bergstr.**

(73) Patentinhaber : **Siemens Aktiengesellschaft Berlin und München**
**Wittelsbacherplatz 2**
**D-8000 München 2 (DE)**

(72) Erfinder : **Ahne, Hellmut, Dr.**
**Heidestrasse 6**
**D-8551 Röttenbach (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

**Beschreibung**

Die Erfindung betrifft ein Verfahren zur Herstellung oligomer und/oder polymerer strahlungsreaktiver Vorstufen von Polyimidazolen und Polyimidazopyrrolonen sowie die Verwendung dieser strahlungsreaktiven Vorstufen.

Polyimidazole zeichnen sich durch eine außergewöhnliche chemische Resistenz gegen Säuren und Basen aus, und von Polyimidazopyrrolonen ist bekannt, daß sie im Vergleich zu Polyimiden gegen harte Strahlung eine nahezu doppelt so hohe Resistenz aufweisen. Es wird daher angestrebt, diese besonderen Eigenschaften der genannten Polymerarten auf dem Gebiet der Feinstrukturerzeugung zu nutzen. Dazu ist es aber erforderlich, daß lösliche strahlungsreaktive Vorstufen dieser Polymeren verfügbar sind, aus denen mittels photolithographischer Prozesse feine Strukturen erzeugt werden können.

Strahlungsreaktive Polyimidazol- und Polyimidazopyrrolon-Vorstufen sind bereits bekannt (DE-OS 29 33 819), und zwar in Form von Additionsprodukten von olefinisch ungesättigten Monoepoxiden an aminogruppenhaltige Polykondensationsprodukte von aromatischen und/oder heterocyclischen Tetraaminoverbindungen mit Dicarbonsäurechloriden oder -ersten (Polyimidazol-Vorstufen) bzw. an aminogruppenhaltige Polyadditionsprodukte aus den Tetraaminoverbindungen und Tetracarbonsäuredianhydriden (Polyimidazopyrrolon-Vorstufen).

Das vorstehend geschilderte Herstellungsverfahren ist jedoch noch nicht ganz zufriedenstellend. So sind im Falle der Verwendung von Säurechloriden Reinigungsprozesse erforderlich. Darüber hinaus erfordert die Umsetzung der aminogruppenhaltigen Polykondensations- bzw. Polyadditionsprodukte einen Überschuß an ungesättigtem Monoepoxid, was gelegentlich zu Schwierigkeiten bei der Reinigung der Reaktionsprodukte führen kann ; außerdem können dabei längere Reaktionszeiten erforderlich sein. Ferner weisen die erhaltenen Polymer-Vorstufen, offensichtlich infolge unvollständiger Umsetzung und aufgrund von Nebenreaktionen, eine begrenzte Photoempfindlichkeit auf.

Aufgabe der Erfindung ist es, ein Verfahren anzugeben, das in einfacher Weise die Herstellung von in organischen Lösungsmitteln löslichen Polyimidazol- und Polyimidazopyrrolon-Vorstufen erlaubt, die zugleich strahlungsreaktiv und von hoher Reinheit, d. h. insbesondere chloridfrei sind.

Dies wird erfindungsgemäß dadurch erreicht, daß eine aromatische und/oder heterocyclische Tetraaminoverbindung unter Verwendung eines Carbodiimids mit einer olefinisch ungesättigten Monocarbonsäure und einer Dicarbonsäure bzw. entweder mit einer olefinisch ungesättigten Monocarbonsäure und einen aromatischen und/oder heterocyclischen Tetracarbonsäuredianhydrid oder mit einem olefinisch ungesättigten Tetracarbonsäurediester in Form eines Additionsprodukte aus dem Tetracarbonsäuredianhydrid und einem olefinisch ungesättigten Alkohol zur Reaktion gebracht wird.

Unter « Tetracarbonsäuredianhydrid » werden im Rahmen der vorliegenden Patentanmeldung Verbindungen verstanden, die wenigstens zwei Säureanhydridgruppierungen aufweisen. Im übrigen können beim erfindungsgemäßen Verfahren sowohl verschiedene Tetraaminoverbindungen als auch verschiedene Monocarbonsäuren, Dicarbonsäuren und Tetracarbonsäuredianhydride bzw. -diester nebeneinander eingesetzt werden.

Nach dem erfindungsgemäßen Verfahren können Polyimidazol- und Polyimidazopyrrolon-Vorstufen auf einfachem Weg synthetisiert werden, wobei auch relativ einheitliche Reaktionsprodukte entstehen. Im Vergleich zu den bekannten Polyimidazol- und Polyimidazopyrrolon-Vorstufen weisen die nach dem erfindungsgemäßen Verfahren hergestellen Vorstufen — offensichtlich aufgrund eines vollständigeren Umsatzes — einen höheren Anteil an photoempfindlichen Gruppen auf und sind daher strahlungsreaktiver.

Das erfindungsgemäße Verfahren wird im allgemeinen in einem Lösungsmittel durchgeführt. Bei den (Poly)Kondensationsreaktionen, bei denen Carbodiimid eingesetzt wird, scheidet sich dann der dem Carbodiimid zugrundeliegende Harnstoff ab, und zwar bereits bei Raumtemperatur. Dabei werden hochreine, insbesondere chloridfreie Lösungen der strahlungsreaktiven Vorstufen erhalten, da die Vorstufen in organischen Lösungsmitteln gut löslich sind. Die Lösungen der Vorstufen können nach der Abtrennung des als Nebenprodukt in sehr reiner Form anfallenden Harnstoffderivates direkt weiterverwendet werden, was in wirtschaftlicher Hinsicht von Bedeutung ist. Es kann aber auch in der Weise vorgegangen werden, daß die Vorstufen durch Ausfällen als Festharz isoliert werden. Auf jeden Fall können aber aus Lösungen der Vorstufen homogene Schichten in einem weiten Schichtdickenbereich hergestellt und beispielsweise durch UV-Bestrahlung gehärtet werden.

Die Herstellung von Polyimidazol-Vorstufen erfolgt im allgemeinen in der Weise, daß die Tetraaminoverbindung entweder zunächst mit der olefinisch ungesättigten Monocarbonsäure umgesetzt und das dabei gebildete Kondensationsprodukt dann mit der Dicarbonsäure polykondensiert wird oder daß die Tetraaminoverbindung zunächst mit der Dicarbonsäure umgesetzt und an das dabei gebildete Polykondensationsprodukt dann die olefinisch ungesättigte Monocarbonsäure ankondensiert wird. Jede dieser Umsetzungen wird dabei in Gegenwart von Carbodiimid durchgeführt.

Zur Herstellung von Polyimidazopyrrolon-Vorstufen wird die Tetraaminoverbindung entweder zunächst in Gegenwart von Carbodiimid mit der olefinisch ungesättigten Monocarbonsäure umgesetzt und das dabei gebildete Kondensationsprodukt dann an das Tetracarbonsäuredianhydrid polyaddiert oder die Tetraaminoverbindung wird zunächst mit dem Tetracarbonsäuredianhydrid umgesetzt und an das

dabei gebildete Polyadditionsprodukt — in Gegenwart von Carbodiimid — dann die olefinisch ungesättigte Monocarbonsäure ankondensiert.

Werden die Polyimidazopyrrolon-Vorstufen erfindungsgemäß in der Weise hergestellt, daß eine Tetraaminoverbindung — in Gegenwart von Carbodiimid — mit einem olefinisch ungesättigten Tetracarbonsäurediester umgesetzt wird, so kann an das dabei gebildete Polykondensationsprodukt vorteilhaft zusätzlich noch eine ungesättigte Monocarbonsäure ankondensiert werden, und zwar ebenfalls in Gegenwart von Carbodiimid. Dabei werden in die Vorstufen zusätzliche strahlungsempfindliche Gruppen eingeführt, was eine weitere Steigerung der Photoreaktivität bewirkt.

Entsprechende Polyimidazopyrrolon-Vorstufen mit gesteigerter Photoreaktivität können — gemäß einer weiteren Variante der Erfindung — auch in der Weise hergestellt werden, daß die Tetraaminoverbindung zunächst — mittels Carbodiimid — mit einer olefinisch ungesättigten Monocarbonsäure Umgesetzt wird und das dabei gebildete Kondensationsprodukt anschließend, ebenfalls in Gegenwart von Carbodiimid, mit einem olefinisch ungesättigten Tetracarbonsäurediester polykondensiert wird. Anstelle des Tetracarbonsäurediesters kann auch eine Tetracarbonsäure verwendet werden, die dabei erhaltenen Vorstufen sind dann aber weniger strahlungsreaktiv.

Das erfindungsgemäße Verfahren ist präparativ einfach durchzuführen, wobei im allgemeinen Reaktionstemperaturen von 0 bis 50 °C ausreichend sind. Da an der Reaktion keine Säurechloride beteiligt sind, entfallen aufwendige Reinigungsoperationen. Darüber hinaus fallen die Reaktionsprodukte, einschließlich der als Nebenprodukte entstehenden Harnstoffderivate, in sehr reinem Zustand an. Im übrigen ist beim erfindungsgemäßen Verfahren die überraschende Tatsache, daß die Reaktionen mit den Carbodiimiden im wesentlichen einheitlich und vollständig verlaufen, d. h. ohne Nebenreaktionen, und insbesondere auch die Tatsache, daß die Harnstoffderivate von den dabei gebildeten Vorstufen gut abgetrennt werden können, von entscheidender Bedeutung.

Die nach dem erfindungsgemäßen Verfahren hergestellten Polymer-Vorstufen eignen sich insbesondere zur Herstellung von strukturierten, hochwärmebeständigen Schutz- und Isolierschichten in der Mikroelektronik (Feinstrukturerzeugung) sowie zur Verwendung als Photoresist.

Die erfindungsgemäß hergestellten strahlungsreaktiven Vorstufen weisen im allgemeinen folgende Struktur auf :

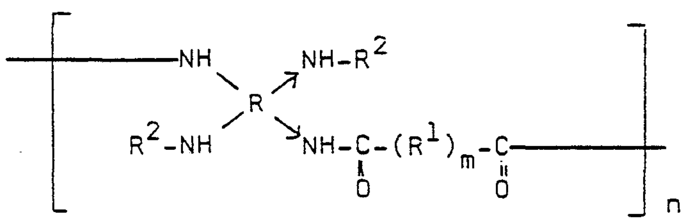

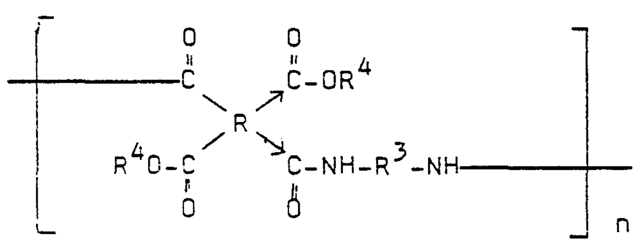

Mit den in den Formeln — die erste Formel steht dabei für Polyimidazol-Vorstufen und die zweite Formel für Polyimidazopyrrolon-Vorstufen — enthaltenen Pfeilen soll die Tatsache zum Ausdruck gebracht werden, daß die beiden fraglichen Substituenten an R ihre Stellung vertauschen können. Dies ist deshalb von Bedeutung, weil es sich bei R, wie nachfolgend noch erläutert wird, um einen cyclischen Rest handelt.

In den Formeln bedeutet n eine ganze Zahl von 2 bis etwa 100 und m ist 0 oder 1.

Für R, $R^1$, $R^2$, $R^3$ und $R^4$ gilt folgendes :

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die freien Valenzen jeweils an endständigen derartigen Strukturelementen ;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, beispielsweise eine allyletherhaltige Gruppe, insbesondere eine — gegebenenfalls substituierte — (meth)acrylesterhaltige Gruppe oder eine Propargylgruppe ;

$R^3$ ist ein zumindest partiell aromatischer und/oder heterocyclischer divalenter, d. h. difunktioneller Rest, bei dem wenigstens zu einer der beiden Valenzen in Nachbarstellung eine Aminogruppe angeordnet ist; weist $R^3$ mehrere aromatische und/oder heterocyclische Strukturelemente auf, so befinden sich die freien Valenzen jeweils an endständigen derartigen Strukturelementen;

$R^4$ ist Wasserstoff oder $R^2$.

Die Reste R, $R^1$, $R^2$, $R^3$ und $R^4$ haben insbesondere folgende Bedeutung:

R = 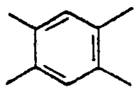, 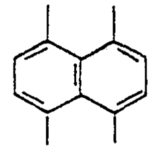, 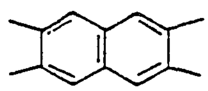, 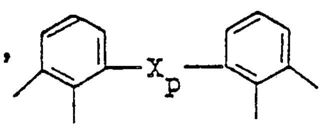,

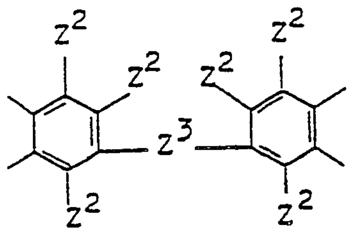, 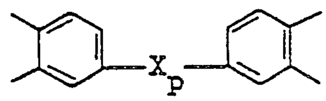,

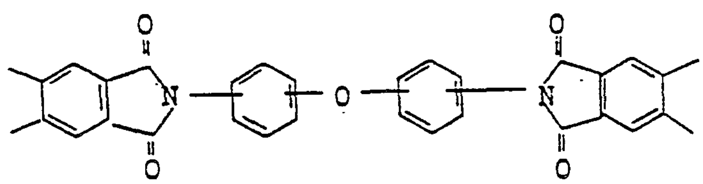,

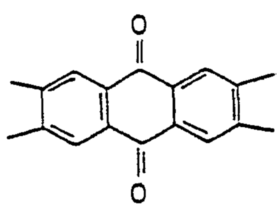, 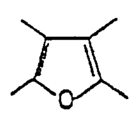 und 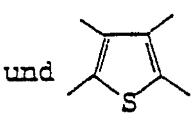,

wobei p = 0 oder 1 ist und X für einen der nachfolgenden Reste steht.

X = 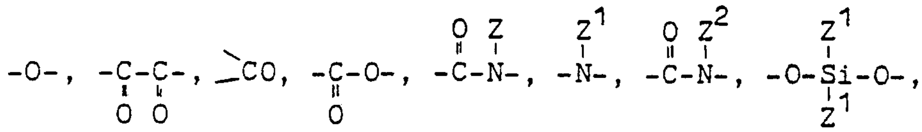

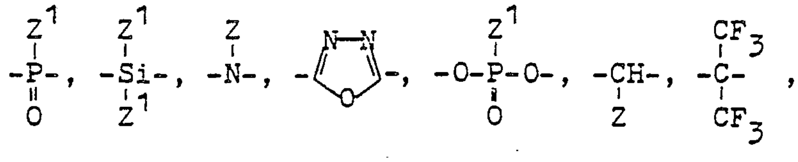

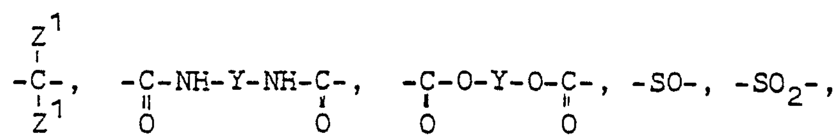

$-SO_2NH-$, $-S-$, 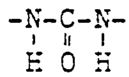, $-N=N-$,

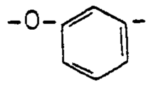, 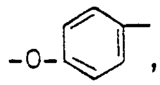, 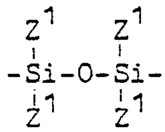 und 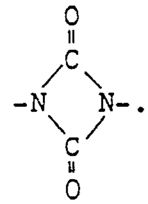.

Für die weiteren Reste gilt :

Y = 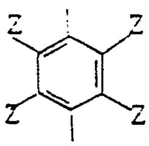, $-(CH_2)_o-$ mit o=2 bis 10, und

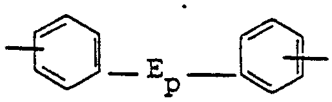 mit p=0 oder 1,

Z = H oder Alkyl mit 1 bis Kohlenstoffatomen,
$Z^1$ = Alkyl mit 1 bis 10 Kohlenstoffatomen oder Aryl,
$Z^2$ = Aryl oder Heteroaryl, und
$Z^3$ =

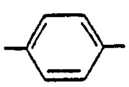 oder 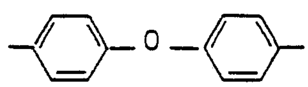 ;

E = 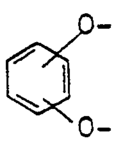, 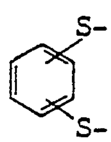, 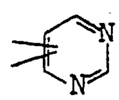, 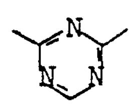, 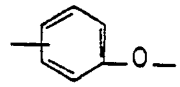,

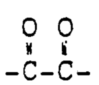, 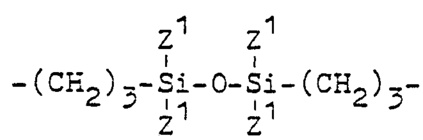, 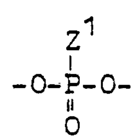, 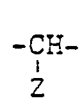,

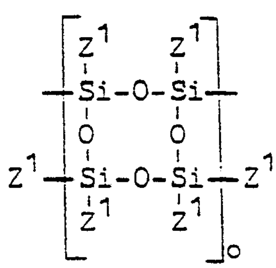, 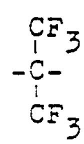,

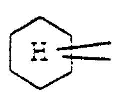, $-(CH_2)_q-$, $-(CF_2)_r-$, $-SO-$, $-SO_2-$,

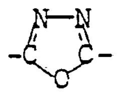, $-SO_2NH-$, 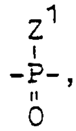, 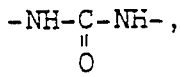, 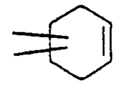,

$-N=N-$, 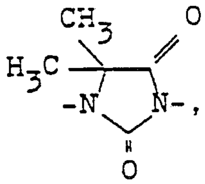, $-S-$, $-O-$, 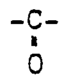, 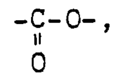,

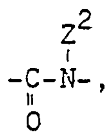, 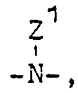, 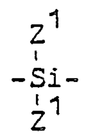, 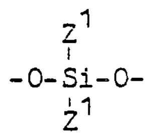 und 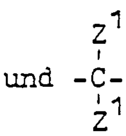,

wobei o = 2 bis 10, q = 2 bis 14 und r = 2 bis 18, und $Z^1$ und $Z^2$ wie vorstehend definiert sind.

$R^1$ = 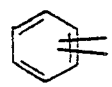, 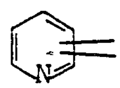, 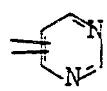, 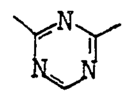, 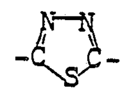,

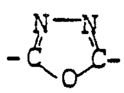, 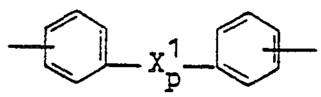,

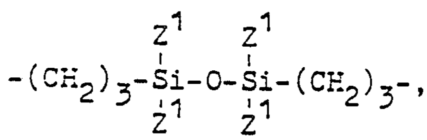, 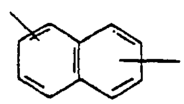, 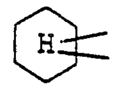,

$-(CH_2)_q-$, $-(CF_2)_r-$, 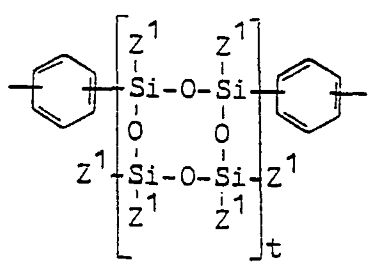,

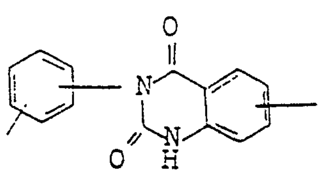, 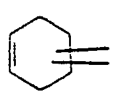, 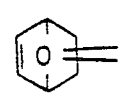, 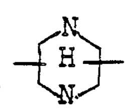,

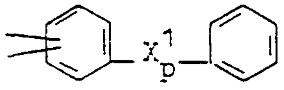, 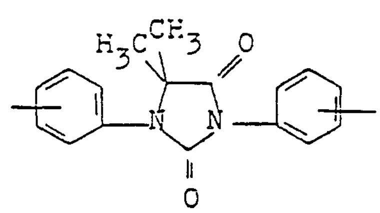,

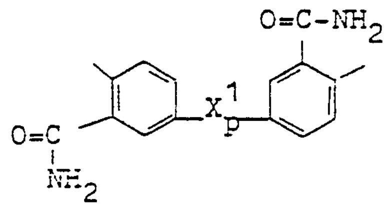

und

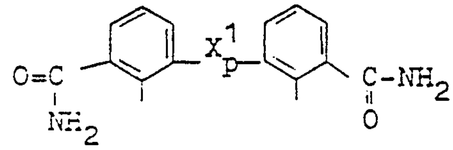,

wobei p = 0 oder 1, q = 2 bis 14, r = 2 bis 18 und t = 1 bis 10, und $Z^1$ wie vorstehend definiert ist;

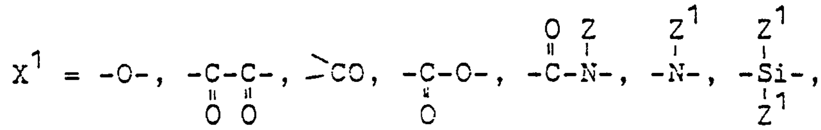

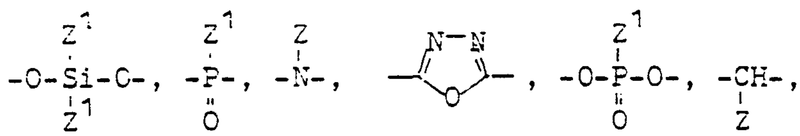

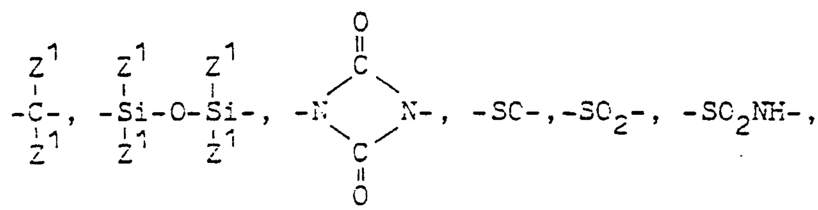

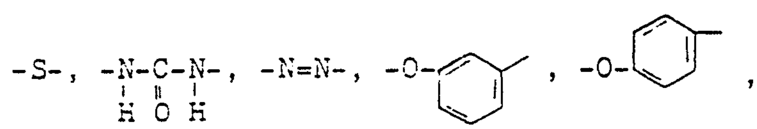

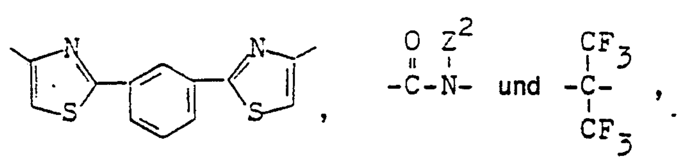

wobei Z, $Z^1$ und $Z^2$ wie vorstehend definiert sind.

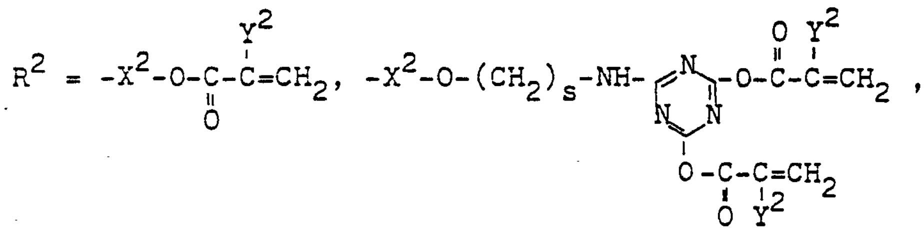

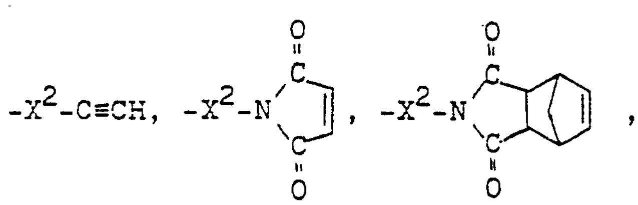

$-X^2-O-CH_2-CH=CH_2$ und $-X^2-O-CH_2-C\equiv CH$;

dabei ist s = 2 bis 16;
für die weiteren Reste gilt:
$X^2 = -(-CH_2-)_r-$ und $-CH_2-O-[(CH_2)_r-O]_t-(CH_2)_s-$, und

$Y^2$ = —H, —$CH_3$, —Cl, —Br oder —C≡N,
wobei r = 2 bis 18, s = 2 bis 16 und t = 1 bis 10.

$R^3$ = 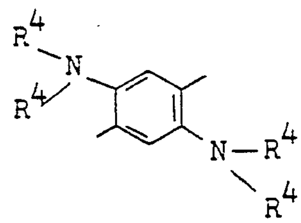 , 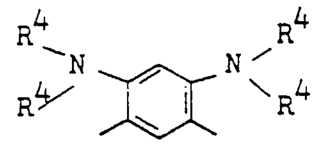 ,

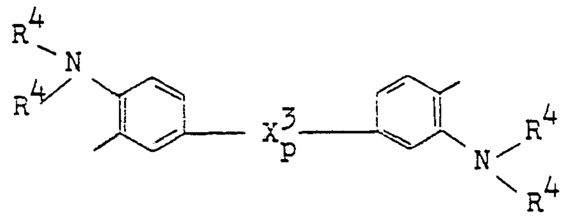 und

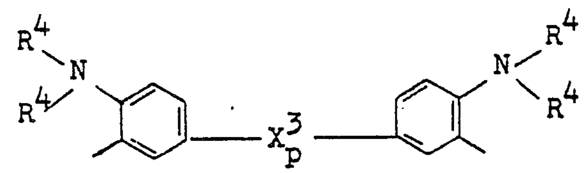 ;

dabei ist p = 0 oder 1 und $X^3$ hat die vorstehend für $X^1$ angegebene Bedeutung.

Die nach dem erfindungsgemäßen Verfahren hergestellten strahlungsreaktiven Vorstufen sind im wesentlichen Polykondensationsprodukte von Tetraaminoverbindungen mit Dicarbonsäuren (Polyimidazol-Vorstufen) bzw. Polyadditionsprodukte aus den Tetraaminoverbindungen und Tetracarbonsäuredianhydriden und Polykondensationsprodukte aus den Tetraaminoverbindungen und Tetracarbonsäurediestern (Polyimidazopyrrolon-Vorstufen). Als Tetraaminoverbindung wird dabei Diaminobenzidin bevorzugt. Die bevorzugt eingesetzte Dicarbonsäure ist Isophthalsäure und das bevorzugte Tetracarbonsäuredianhydrid Pyrromellithsäuredianhydrid. Beim erfindungsgemäßen Verfahren werden ferner olefinisch ungesättigte Monocarbonsäuren eingesetzt, wobei Acrylsäure und Methacrylsäure bevorzugt werden. Unter den ebenfalls zum Einsatz gelangenden olefinisch ungesättigten Alkoholen finden insbesondere Hydroxyethylacrylat und Hydroxyethylmethacrylat Verwendung. Das bevorzugt eingesetzte Carbodiimid ist Dicyclohexylcarbodiimid ; Carbodiimide sind im übrigen Verbindungen vom Typ R'—N=C=N—R''.

Die erfindungsgemäß hergestellten Vorstufen weisen als Grundbausteine bevorzugt aromatische Aminoverbindungen auf und ergeben somit bei der thermischen Behandlung : Polymere mit folgenden Struktureinheiten :

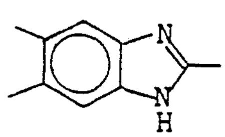 ; 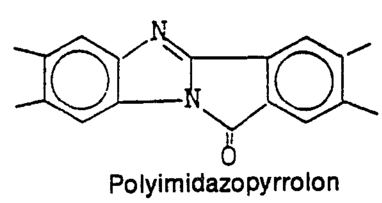

Polyimidazol Polyimidazopyrrolon

Außer zur Verwendung als Photoresist und zur Herstellung von Schutz- und Isolierschichten, wobei eine Strukturierung erfolgt, können die erfindungsgemäßen Vorstufen auch allgemein — in nicht strukturierter Form — zur Herstellung von Schutz- und Isolierüberzügen dienen.

Anhand von Ausführungsbeispielen soll die Erfindung noch näher erläutert werden.

Beispiel 1

Herstellung einer strahlungsreaktiven Polybenzimidazol-Vorstufe

21,4 Gewichtsteile Diaminobenzidin (0,1 Mol) und 16 Gewichtsteile Methacrylsäure (0,19 Mol) werden in 70 Volumenteilen N-Methylpyrrolidon gelöst. Unter Rühren und Kühlung auf 10 °C werden zu dieser Lösung dann 42 Gewichtsteile Dicyclohexylcarbodiimid (0,2 Mol) in 100 Volumenteilen γ-Butyrolacton getropft. Nach beendeter Zugabe bleibt die Reaktionslösung noch 3 h bei Raumtemperatur stehen. Danach werden zur Reaktionslösung 16,6 Gewichsteile Isophthalsäure gegeben und anschließend

wird — unter Rühren und Kühlung auf 8 °C — eine Lösung von 42 Gewichtsteilen Dicyclohexylcarbodiimid (0,2 Mol) in 120 Volumenteilen γ-Butyrolacton langsam zugetropft. Dabei bildet sich bald eine viskose Harzlösung, die bei Raumtemperatur 18 h stehengelassen wird. Nachfolgend wird der Dicyclohexylharnstoff abfiltriert, wobei eine klare Harzlösung erhalten wird. Diese Harzlösung wird auf ein Aluminiumblech ausgegossen und bei einem Druck von $1,3 \times 10^4$ Pa und einer Temperatur von 40 °C getrocknet. Dabei entstehen homogene Filme, die bei Belichtung mit einer 350 W-Quecksilberhöchstdrucklampe — in Abhängigkeit von der Schichtstärke — im Zeitraum von wenigen Minuten gehärtet werden können.

Beispiel 2

Herstellung einer strahlungsreaktiven Polyimidazopyrrolon-Vorstufe

Zu 21,8 Gewichtsteilen Pyrromellithsäuredianhydrid (0,1 Mol) in 50 Volumenteilen N-Methylpyrrolidon werden unter Rühren und Feuchtigkeitsausschluß 26 Gewichtsteile Hydroxyethylmethacrylat (0,2 Mol) gegeben. Die Reaktionsmischung wird dann 20 h bei Raumtemperatur stehengelassen. Der titrimetisch ermittelte Carboxylgehalt beträgt 0,21 Mol/100 g. Unter Rühren wird zur Reaktionslösung dann eine Lösung von 20,4 Gewichtsteilen Diaminobenzidin (0,09 Mol) in 70 Volumenteilen N-Methylpyrrolidon gegeben. Anschließend wird zu der auf eine Temperatur von 5 bis 10 °C gekühlten Lösung eine Lösung von 42 Gewichtsteilen Dicyclohexylcarbodiimid (0,2 Mol) in 120 Volumenteilen γ-Butyrolacton zugetropft. Nach beendeter Zugabe wird die viskose Reaktionslösung bei Raumtemperatur 20 h stehengelassen und danach durch Filtration vom ausgefallenen Dicyclohexylharnstoff befreit. Beim Eintropfen der Harzlösung in destilliertes Wasser unter Rühren fällt eine gelbe Festsubstanz aus, die nach dem Trocknen bei einer Temperatur von 40 °C und einem Druck von $1,3 \times 10^4$ Pa ein gelbes Harzpulver ergibt. Im IR-Spektrum sind die für Methacrylate typischen Absorptionen bei 950 und 1 630 $cm^{-1}$ vorhanden.

**Patentansprüche**

1. Verfahren zur Herstellung oligomerer und/oder polymerer strahlungsreaktiver Vorstufen von a) Polyimidazolen und b) Polyimidazopyrrolonen, dadurch gekennzeichnet, daß eine aromatische und/oder heterocyclische Tetraaminoverbindung unter Verwendung eines Carbodiimids

a) mit einer olefinisch ungesättigten Monocarbonsäure und einer Dicarbonsäure bzw.

b) entweder mit einer olefinisch ungesättigten Monocarbonsäure und einem aromatischen und/oder heterocyclischen Tetracarbonsäuredianhydrid oder mit einem olefinisch ungesättigten Tetracarbonsäurediester gebildet aus dem Tetracarbonsäuredianhydrid und einem olefinisch ungesättigten Alkohol

zur Reaktion gebracht wird.

2. Verfahren zur Herstellung von Polyimidazol-Vorstufen nach Anspruch 1, dadurch gekennzeichnet, daß die Tetraaminoverbindung entweder zunächst mit der olefinisch ungesättigten Monocarbonsäure umgesetzt und das dabei gebildete Kondensationsprodukt mit der Dicarbonsäure polykondensiert wird oder zunächst mit der Dicarbonsäure umgesetzt und an das dabei gebildete Polykondensationsprodukt die olefinisch ungesättigte Monocarbonsäure ankondensiert wird, wobei jede dieser Umsetzungen in Gegenwart von Carbodiimid durchgeführt wird.

3. Verfahren zur Herstellung von Polyimidazopyrrolon-Vorstufen nach Anspruch 1, dadurch gekennzeichnet, daß die Tetraaminoverbindung entweder zunächst in Gegenwart von Carbodiimid mit der olefinisch ungesättigten Monocarbonsäure umgesetzt und das dabei gebildete Kondensationsprodukt an das Tetracarbonsäuredianhydrid polyaddiert wird oder zunachst mit dem Tetracarbonsäuredianhydrid umgesetzt und an das dabei gebildete Polyadditionsprodukt in Gegenwart von Carbodiimid die olefinisch ungesättigte Monocarbonsäure ankondensiert wird.

4. Verfahren zur Herstellung von Polyimidazopyrrolon-Vorstufen nach Anspruch 1, dadurch gekennzeichnet, daß an das durch Umsetzung der Tetraaminoverbindung mit dem olefinisch ungesättigten Tetracarbonsäurediester gebildete Polykondensations produkt in Gegenwart von Carbodiimid eine olefinisch ungesättigte Monocarbonsäure ankondensiert wird.

5. Verfahren nach einem der Ansprüche 1 bis 4, dadurch gekennzeichnet, daß als Carbodiimid Dicyclohexylcarbodiimid eingesetzt wird.

6. Verfahren nach einem oder mehreren der Ansprüche 1 bis 5, dadurch gekennzeichnet, daß als Tetraaminoverbindung Diaminobenzidin eingesetzt wird.

7. Verfahren nach einem oder mehreren der Ansprüche 1 bis 6, dadurch gekennzeichnet, daß als olefinisch ungesättigte Monocarbonsäure Acrylsäure oder Methacrylsäure eingesetzt wird.

8. Verfahren nach einem oder mehreren der Ansprüche 1 bis 7, dadurch gekennzeichnet, daß als Dicarbonsäure Isophthalsäure eingesetzt wird.

9. Verfahren nach einem oder mehreren der Ansprüche 1 bis 8, dadurch gekennzeichnet, daß als Tetracarbonsäuredianhydrid Pyrromellithsäureanhydrid eingesetzt wird.

10. Verfahren nach einem oder mehreren der Ansprüche 1 bis 9, dadurch gekennzeichnet, daß als olefinisch ungesättigter Alkohol Hydroxyethylacrylat oder Hydroxyethylmethacrylat eingesetzt wird.

11. Strahlungsreaktive Vorstufen, hergestellt nach einem oder mehreren der Ansprüche 1 bis 10.

12. Verwendung der strahlungsreaktiven Vorstufen nach Anspruch 11 zur Herstellung von Schutz- und Isolierschichten, insbesondere auf elektrischen Bauteilen.

**Claims**

1. A process for preparing oligomeric and/or polymeric radiation-reactive precursors of a) polyimidazoles and b) polyimidazopyrrolones, characterised in that an aromatic and/or heterocyclic tetra-amino compound is caused to react using a carbodiimide

a) with an olefinically-unsaturated monocarboxylic acid and a dicarboxylic acid, or

b) either with an olefinically-unsaturated monocarboxylic acid and an aromatic and/or heterocyclic tetracarboxylic acid dianhydride, or an olefinically-unsaturated tetracarboxylic acid diester formed from the tetracarboxylic acid dianhydride and an olefinically-unsaturated alcohol.

2. A process for the production of polyimidazole precursors as claimed in Claim 1, characterised in that the tetra-amino compound is either first caused to react with the olefinically-unsaturated monocarboxylic acid and the condensation product so formed is polycondensed with the dicarboxylic acid, or is first caused to react with the dicarboxylic acid and the olefinically-unsaturated monocarboxylic acid is condensed onto the polycondensation product thereby produced, each of the reactions being carried out in the presence of carbodiimide.

3. A process for the production of polyimidazopyrrolone precursors as claimed in Claim 1, characterised in that the tetra-amino compound is either first caused to react with the olefinically-unsaturated monocarboxylic acid in the presence of carbodiimide and the condensation product so formed is poly-added to the tetracarboxylic acid dianhydride, or is first caused to react with the tetracarboxylic acid dianhydride and the olefinically-unsaturated monocarboxylic acid is condensed onto the polyaddition product so formed, in the presence of carbodiimide.

4. A process for the production of polyimidazopyrrolone precursors as claimed in Claim 1, characterised in that, in the presence of carbodiimide, an olefinically-unsaturated monocarboxylic acid is condensed onto the polycondensation product with is formed by reaction of the tetra-amino compound with the olefinically-unsaturated tetracarboxylic acid diester.

5. A process as claimed in one of Claims 1 to 4, characterised in that dicyclohexylcarbodiimide is used as carbodiimide.

6. A process as claimed in one or more of Claims 1 to 5, characterised in that diaminobenzidine is used as tetra-amino compound.

7. A process as claimed in one or more of Claims 1 to 6, characterised in that acrylic acid, or methacrylic acid, is used as olefinically-unsaturated monocarboxylic acid.

8. A process as claimed in one or more of Claims 1 to 7, characterised in that isophthalic acid is used as dicarboxylic acid.

9. A process as claimed in one or more of Claims 1 to 8, characterised in that pyro-mellitic acid anhydride is used as tetracarboxylic acid dianhydride.

10. A process as claimed in one or more of Claims 1 to 9, characterised in that hydroxyethyl acrylate or hydroxyethyl methacrylate is used as olefinically-unsaturated alcohol.

11. Radiation-reactive precursors produced in accordance with one or more of Claims 1 to 10.

12. The use of the radiation-reactive precursors as claimed in Claim 11 for the production of protective and insulating layers, in particular on electrical components.

**Revendications**

1. Procédé de préparation de précurseurs, oligomères et/ou polymères, réactifs aux rayonnements de a) polyimidazole et b) polymidazopyrrolone, caractérisé en ce qu'il consiste à faire réagir un composé aromatique et/ou hétérocyclique tétraaminé, tout en utilisant un carabodiimide

a) sur un acide monocarboxylique à insaturation oléfinique et sur un acide dicarboxylique ou

b) sur un acide monocarboxylique à insaturation oléfinique et sur un dianhydride d'acide tétracarboxylique aromatique et/ou hétérocyclique, ou sur un diester d'acide tétracarboxylique à insaturation oléfinique formé à partir du dianhydride d'acide tétracarboxylique et d'un alcool à insaturation oléfinique.

2. Procédé de préparation de précurseurs de polyimidazole suivant la revendication 1, caractérisé en ce qu'il consiste à faire réagir le composé tétraaminé d'abord sur l'acide monocarboxylique à insaturation oléfinique, et à polycondenser avec l'aide dicarboxylique le produit de condensation ainsi formé, ou à le faire réagir d'abord sur l'acide dicarboxylique et à condenser l'acide monocarboxylique à insaturation oléfinique sur le produit de polycondensation ainsi formé, chacune de ces réactions étant effectuée en présence de carbodiimide.

3. Procédé de préparation de précurseurs de polyimidazopyrrolone suivant la revendication 1, caractérisé en ce qu'il consiste à faire réagir le composé tétraaminé d'abord, en présence de

carbodiimide, sur l'acide monocarboxylique à insaturation oléfinique, et à effectuer une polyaddition du produit de condensation ainsi formé sur le dianhydride d'acide tétracarboxylique, ou à le faire réagir d'abord sur le dianhydride d'acide tétracarboxylique, et à condenser sur le produit de polyaddition ainsi formé, l'acide monocarboxylique à insaturation oléfinique en présence de carbodiimide.

4. Procédé de préparation de précurseurs de polyimidazopyrrolone suivant la revendication 1, caractérisé en ce qu'il consiste à condenser, en présence de carbodiimide, un acide monocarboxylique à insaturation oléfinique, sur le produit de polycondensation formé par la réaction du composé tétraaminé sur le diester d'acide tétracarboxylique à insaturation oléfinique.

5. Procédé suivant l'une des revendications 1 à 4, caractérisé en ce qu'il consiste à mettre en œuvre, comme carbodiimide, du dicyclohexylcarbodiimide.

6. Procédé suivant l'une ou plusieurs des revendications 1 à 5, caractérisé en ce qu'il consiste à mettre en œuvre, comme composé tétraaminé, de la diaminobenzidine.

7. Procédé suivant l'une ou plusieurs des revendications 1 à 6, caractérisé en ce qu'il consiste à mettre en œuvre, comme acide monocaarboxylique à insaturation oléfinique, de l'acide acrylique ou de l'acide méthacrylique.

8. Procédé suivant l'une ou plusieurs des revendications 1 à 7, caractérisé en ce qu'il consiste à mettre en œuvre, comme acide dicarboxylique, de l'acide isophtalique.

9. Procédé suivant l'une ou plusieurs des revendications 1 à 8, caractérisé en ce qu'il consiste à mettre en œuvre, comme dianhydride d'acide tétracarboxylique, de l'anhydride d'acide pyrromellithique.

10. Procédé suivant l'une ou plusieurs des revendications 1 à 9, caractérisé en ce qu'il consiste à mettre en œuvre, comme alcool à insaturation oléfinique, de l'acrylate d'hydroxyéthyle ou du méthacrylate d'hydroxyéthyle.

11. Précurseurs réactifs au rayonnement préparés suivant l'une ou plusieurs des revendications 1 à 10.

12. Utilisation des précurseurs réactifs au rayonnement suivant la revendication 11, pour la fabrication de couches de protection et de couches isolantes, notamment sur des composants électriques.